# EUROPEAN PATENT APPLICATION

(11) **EP 4 518 600 A1**
(43) Date of publication of application: **05.03.2025**
(21) Application number: 23306450.0
(22) Date of filing: 31.08.2023
(51) Int. Cl.: H05K 7/20

(54) **SHARING DATACENTER LIQUID COOLING RESOURCES IN CASE OF COMPONENT FAILURE**

(71) Applicant: OVH, 59100 Roubaix (FR)
(72) Inventor: CHEHADE, Ali, 59283 Moncheaux (FR)
(74) Representative: BCF Global

(57) **Abstract**

A datacenter liquid cooling resource sharing system and process is presented that comprises two liquid cooling arrangements having a common liquid sharing support circuit between the two arrangements that incorporates respective first switchover control valves coupled to the forward cooling liquid supply and respective second switchover control valves coupled to the return heated liquid supply. In response to receiving data indicating a detected liquid flow failure, the first or second control module panels identify which of the forward liquid cooling circuits has detected a liquid flow failure, shut down the respective forward cooling liquid circuit and return heated liquid circuit, open the first switchover valve to route a suitable portion of the cooling liquid flow from the operational forward liquid circuit to the failing forward liquid circuit, and open the second switchover valve to route a suitable portion of the heated liquid flow from the failing return liquid circuit to the operational return liquid circuit.

## Description

### FIELD

The present technology generally relates to the field of datacenter liquid cooling arrangements and, in particular, to the sharing of datacenter liquid cooling resources in the event of flow component failures.

### BACKGROUND

Datacenters as well as many computer processing facilities house multitudes rack-mounted electronic processing equipment. In operation, such electronic processing equipment generates a substantial amount of heat that must be dissipated in order avoid electronic component failures and ensure continued efficient processing operations.

To this end, various liquid cooling measures have been implemented to facilitate the dissipation of heat generated by the electronic processing equipment. One such measure employs liquid block cooling techniques for directly cooling one or more heat-generating processing components. This technique utilizes liquid cooling blocks having internal channels that receive cooling liquid from a cooling liquid source that are in thermal contact with the heat-generating processing components.

Depending on the access to water resources, in many cases, the preferred cooling liquid source comprises a dry cooling unit. Dry cooling units supply cooling liquid via pumps to rack-mounted electronic processing equipment as well as receive heated liquid from the electronic processing equipment and are configured to re-cool the received heated liquid for circulation back to the electronic processing equipment.

At times, certain components crucial to liquid flow of the liquid cooling arrangement, such as, for example, pumps or dry cooling unit, fail. The failure of such flow components can result in damaging effects to the multitudes of the heat-generating processing components serviced by the liquid cooling arrangement.

As such, there remains an interest in attempting to minimize the damaging effects due to crucial flow component failures of a single liquid cooling arrangement by sharing liquid cooling components/resources of other liquid cooling arrangements.

The subject matter discussed in the background section should not be assumed to be prior art merely as a result of its mention in the background section. Similarly, a problem mentioned in the background section or associated with the subject matter of the background section should not be assumed to have been previously recognized in the prior art. The subject matter in the background section merely represents different approaches.

### SUMMARY

Embodiments of the present technology have been developed based on certain drawbacks associated with conventional dry cooling techniques and implementations.

In one aspect of the inventive concepts, the present technology provides a datacenter liquid cooling system comprising a first cooling arrangement comprising a first dry cooling unit configured to supply a cooling liquid to the rack-mounted processing assemblies and receive a heated liquid from the rack-mounted processing assemblies, a first forward liquid distribution circuit including a temperature sensor, at least one first pump, a pump pressure sensor, a liquid flow volume sensor , and a forward smart control or solenoid valve to convey the cooling liquid from the dry cooling unit to the rack-mounted processing assemblies , a first return liquid distribution circuit including a return smart control solenoid valve to convey the heated liquid from the rack-mounted processing assemblies back to the first dry cooling unit and a temperature sensor , a first control module panel communicatively-coupled to the temperature sensor , pump pressure sensor , liquid flow volume sensor , temperature sensor , and forward smart control or solenoid valve to receive data therefrom, each of the rack-mounted data processing assemblies comprising at least one heat-generating electronic processing element and at least one liquid cooling block arranged to be in respective thermal contact with the at least one heat-generating electronic processing element and fluidly-coupled to the first forward liquid distribution circuit and smart flow valves respectively arranged to be fluidly-coupled to the at least one liquid cooling block of the corresponding rack-mounted data processing assembly, and a second cooling arrangement comprising a second dry cooling unit configured to supply a cooling liquid to the rack-mounted processing assemblies and receive a heated liquid from the rack-mounted processing assemblies , a second forward liquid distribution circuit including a temperature sensor , at least one second pump , a pump pressure sensor , a liquid flow volume sensor , and a forward smart control or solenoid valve , a second return liquid distribution circuit including a return smart control solenoid valve to convey the heated liquid from the rack-mounted processing assemblies back to the first dry cooling unit and a temperature sensor , a second control module panel communicatively-coupled to the temperature sensor , pump pressure sensor , liquid flow volume sensor , temperature sensor , and forward smart control or solenoid valve to receive data therefrom, each of the rack-mounted data processing assemblies comprising at least one heat-generating electronic processing element and at least one liquid cooling block arranged to be in respective thermal contact with the at least one heat-generating electronic processing element and fluidly-coupled to the first liquid distribution circuit and smart control valves respectively arranged to be fluidly-coupled to the at least one liquid cooling block of the corresponding rack-mounted data processing assembly.

The datacenter liquid cooling system further incorporates a liquid sharing support circuit comprising a first switchover control valve fluidly coupled to the forward liquid distribution circuits of the corresponding first and second cooling arrangements that convey the cooling liquid from the dry cooling units, a second switchover control valve fluidly coupled to the return liquid distribution circuits of the corresponding first and second cooling arrangements that convey the heated liquid back to the dry cooling units; and wherein, in response to receiving data indicating a detected liquid flow failure, the first or second control module panels operate to: identify which of the forward liquid cooling circuits has experienced a detected liquid flow failure, shut down the respective forward cooling liquid distribution circuit and return heated liquid distribution circuit of the identified flow failing first or second cooling arrangements, open the first switchover valve to route a suitable portion of the cooling liquid flow from the operational forward liquid distribution circuit to the identified failing forward liquid distribution circuit, and open the second switchover valve to route a suitable portion of the heated liquid flow from the identified failing return liquid distribution circuit to the operational return liquid distribution circuit.

The datacenter liquid cooling system also provides that the first switchover valve is fluidly coupled to the forward liquid distribution circuits at respective coupling points that are proximately disposed downstream from the forward smart control valves and upstream from the respective processing assemblies and that the second switchover valve is fluidly coupled to the return liquid distribution circuits at respective coupling points that are proximately disposed downstream from the respective processing assemblies and upstream from the return smart control valves.

The datacenter liquid cooling system additionally provides that each of the control panel modules are configured to monitor the received data from the respective the temperature sensors, pump pressure sensors, volume sensors, and forward smart control/solenoid valves to determine a detected liquid flow failure and issue alerts regarding corresponding detected liquid flow failures of a cooling arrangement.

The datacenter liquid cooling system further provides that after opening the first and second switchover valves, the control panel modules operate to activate both pumps of the operational forward liquid circuit to maximize liquid cooling flow routed to the identified failing cooling arrangement.

The datacenter liquid cooling system also provides that after opening the first and second switchover valves, the control panel modules operate to increase the speed of the fan assemblies of the dry cooling unit pertaining to the operational cooling arrangement to maximize the cooling liquid flow routed to the identified failing cooling arrangement.

In a related aspect of the inventive concepts, the present technology provides a datacenter liquid cooling resource sharing method, in which the datacenter includes a first dry cooling unit configured to supply a cooling liquid to the rack-mounted processing assemblies and receive a heated liquid from the rack-mounted processing assemblies, a first forward liquid distribution circuit including a temperature sensor, at least one first pump, a pump pressure sensor, a liquid flow volume sensor, and a forward smart control or solenoid valve to convey the cooling liquid from the dry cooling unit to the rack-mounted processing assemblies, a first return liquid distribution circuit including a return smart control solenoid valve to convey the heated liquid from the rack-mounted processing assemblies back to the first dry cooling unit and a temperature sensor, a first control module panel communicatively-coupled to the temperature sensor, pump pressure sensor, liquid flow volume sensor, temperature sensor, and forward smart control or solenoid valve to receive data therefrom, each of the rack-mounted data processing assemblies comprising at least one heat-generating electronic processing element and at least one liquid cooling block arranged to be in respective thermal contact with the at least one heat-generating electronic processing element and fluidly-coupled to the first forward liquid distribution circuit and smart flow valves respectively arranged to be fluidly-coupled to the at least one liquid cooling block of the corresponding rack-mounted data processing assembly, and a second cooling arrangement comprising a second dry cooling unit configured to supply a cooling liquid to the rack-mounted processing assemblies and receive a heated liquid from the rack-mounted processing assemblies, a second forward liquid distribution circuit including a temperature sensor, at least one second pump, a pump pressure sensor, a liquid flow volume sensor, and a forward smart control or solenoid valve, a second return liquid distribution circuit including a return smart control solenoid valve to convey the heated liquid from the rack-mounted processing assemblies back to the first dry cooling unit and a temperature sensor, a second control module panel communicatively-coupled to the temperature sensor, pump pressure sensor, liquid flow volume sensor, temperature sensor, and forward smart control or solenoid valve to receive data therefrom, each of the rack-mounted data processing assemblies comprising at least one heat-generating electronic processing element and at least one liquid cooling block arranged to be in respective thermal contact with the at least one heat-generating electronic processing element and fluidly-coupled to the first liquid distribution circuit and smart control valves respectively arranged to be fluidly-coupled to the at least one liquid cooling block of the corresponding rack-mounted data processing assembly, in which the liquid cooling method comprises providing a liquid sharing support circuit with a first switchover control valve fluidly coupled to the forward liquid distribution circuits of the corresponding first and second cooling arrangements that convey the cooling liquid from the dry cooling units, a second switchover control valve fluidly coupled to the return liquid distribution circuits of the corresponding first and second cooling arrangements that convey the heated liquid back to the dry cooling units wherein, in response to receiving data indicating a detected liquid flow failure, the first or second control module panels identifying which of the forward liquid cooling circuits has experienced a detected liquid flow failure, shutting down the respective forward cooling liquid distribution circuit and return heated liquid distribution circuit of the identified flow failing first or second cooling arrangements, opening the first switchover valve to route a suitable portion of the cooling liquid flow from the operational forward liquid distribution circuit to the identified failing forward liquid distribution circuit, and opening the second switchover valve to route a suitable portion of the heated liquid flow from the identified failing return liquid distribution circuit to the operational return liquid distribution circuit.

The datacenter liquid cooling method also provides for monitoring by each of the control panel modules of the received data from the respective the temperature sensors, pump pressure sensors, volume sensors, and forward smart control/solenoid valves to determine a detected liquid flow failure as well as issuing alerts regarding corresponding detected liquid flow failures of a cooling arrangement.

The datacenter liquid cooling method further provides that, after opening the first and second switchover valves, the control panel modules activating both pumps of the operational forward liquid circuit to maximize liquid cooling flow routed to the identified failing cooling arrangement.

The datacenter liquid cooling method further provides that, after opening the first and second switchover valves increasing the speed of the fan assemblies of the dry cooling unit pertaining to the operational cooling arrangement to maximize the cooling liquid flow routed to the identified failing cooling arrangement.

In the context of the present specification, unless expressly provided otherwise, a computer system may refer, but is not limited to, an "electronic device", an "operation system", a "system", a "computer-based system", a "controller unit", a "monitoring device", a "control device" and/or any combination thereof appropriate to the relevant task at hand.

In the context of the present specification, unless expressly provided otherwise, the expression "computer-readable medium" and "memory" are intended to include media of any nature and kind whatsoever, non-limiting examples of which include RAM, ROM, disks (CD-ROMs, DVDs, floppy disks, hard disk drives, etc.), USB keys, flash memory cards, solid state-drives, and tape drives. Still in the context of the present specification, "a" computer-readable medium and "the" computer-readable medium should not be construed as being the same computer-readable medium. To the contrary, and whenever appropriate, "a" computer-readable medium and "the" computer-readable medium may also be construed as a first computer-readable medium and a second computer-readable medium.

In the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

Implementations of the present technology each have at least one of the above-mentioned object and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
FIG. 1 illustrates a high-level functional block diagram of a datacenter liquid cooling system comprising two liquid arrangements with sharing support capability, in accordance with the nonlimiting embodiments of the present technology;
FIG. 2 illustrates a flow diagram of a datacenter liquid cooling resource sharing process in the event of component failure, in accordance with the nonlimiting embodiments of the present technology; and
FIG. 3 illustrates a high-level functional block diagram of a representative control module panel of a datacenter liquid cooling system, in accordance with the nonlimiting embodiments of the present technology.

It should be appreciated that, unless otherwise explicitly specified herein, the drawings are not to scale.

### DETAILED DESCRIPTION

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any block diagrams herein represent conceptual views of illustrative circuitry embodying the principles of the present technology. Similarly, it will be appreciated that any flowcharts, flow diagrams, state transition diagrams, pseudo-code, and the like represent various processes that may be substantially represented in non-transitory computer-readable media and so executed by a computer or processor, whether or not such computer or processor is explicitly shown.

The functions of the various elements shown in the FIGs. including any functional block labeled as a "processor", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. In some embodiments of the present technology, the processor may be a general-purpose processor, such as a central processing unit (CPU) or a processor dedicated to a specific purpose, such as a digital signal processor (DSP). Moreover, explicit use of the term a "processor" should not be construed to refer exclusively to hardware capable of executing software, and may implicitly include, without limitation, application specific integrated circuit (ASIC), field programmable gate array (FPGA), read-only memory (ROM) for storing software, random access memory (RAM), and non-volatile storage. Other hardware, conventional and/or custom, may also be included.

Software modules, or simply modules which are implied to be software, may be represented herein as any combination of flowchart elements or other elements indicating performance of process steps and/or textual description. Such modules may be executed by hardware that is expressly or implicitly shown. Moreover, it should be understood that module may include for example, but without being limitative, computer program logic, computer program instructions, software, stack, firmware, hardware circuitry or a combination thereof which provides the required capabilities.

Equally noteworthy, while various operations of the inventive concepts may be represented by flowchart elements arranged in certain sequential order, it should be understood that these steps may be combined, sub-divided, re-ordered, or changed to operate concurrently without departing from the teachings of the present technology. In fact, at least some of the processing steps may be executed in parallel or in series. Accordingly, the ordering, sequencing, and grouping of the processing steps is not a limitation of the present technology.

Given this fundamental understanding, the disclosed embodiments are directed to a system and method configured to minimize the damaging effects due to crucial flow component failures of a single liquid cooling arrangement by sharing liquid cooling components/resources of other liquid cooling arrangements.

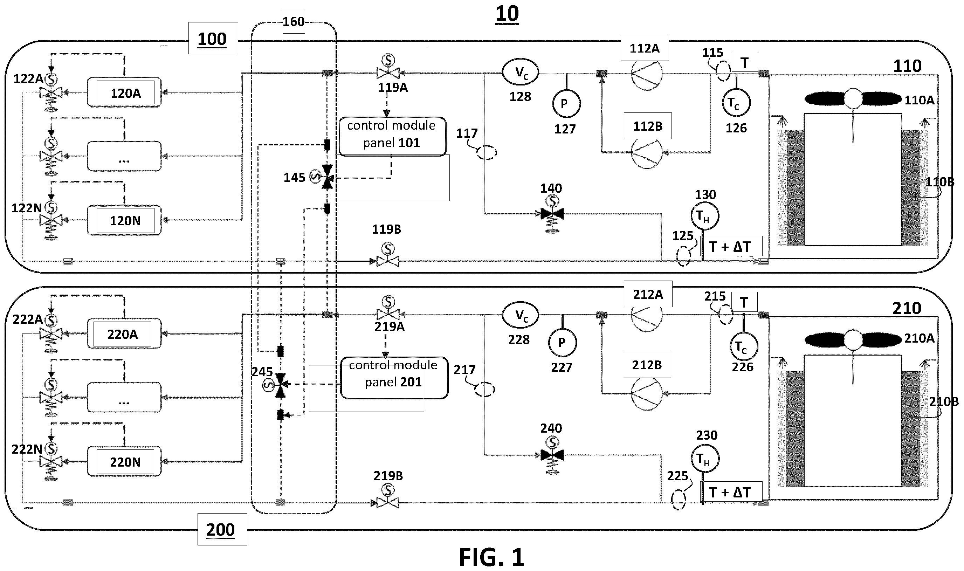

FIG. 1 illustrates a high-level functional block diagram of a datacenter liquid cooling system **10** comprising two liquid cooling arrangements **100, 200** with sharing support capabilities **145, 245** for cooling corresponding rack-mounted processing assemblies, in accordance with the nonlimiting embodiments of the present technology.

As shown, the first liquid cooling arrangement **100** of system **10** includes a dry cooling unit **110,** a plurality of rack-mounted processing assemblies **120A-120N,** a plurality of smart valves **122A-122N** in which each smart valve is fluidly-coupled to a respective processing assembly, a forward liquid distribution circuit **115** incorporating at least one pump **112A, 112B** for supplying cooling liquid from the dry cooling unit **110,** a return liquid distribution circuit **125** for returning heated liquid back to the dry cooling unit **110,** an auxiliary liquid feed circuit **117** for supplementing the cooling liquid flow back to the dry cooling unit **110,** and a control module panel **101** communicatively coupled to various components and sensors.

Similarly, the second liquid cooling arrangement **200** of system **10** includes a dry cooling unit **210,** a plurality of rack-mounted processing assemblies **220A-220N,** a plurality of smart valves **222A-222N** in which each smart valve is fluidly-coupled to a respective processing assembly, a forward liquid distribution circuit **215** incorporating at least one pump **212A, 212B** for supplying cooling liquid from the dry cooling unit **210,** a return liquid distribution circuit **225** for returning heated liquid back to the dry cooling unit **210,** an auxiliary liquid feed circuit **217** for supplementing the cooling liquid flow back to the dry cooling unit **210,** and a control module panel **201** communicatively coupled to various components and sensors.

Each of the dry cooling units **110, 210** may be located on any suitable stable support surface, such as, for example, the roof of a datacenter/computer processing facility building. The dry cooling units **110, 210** serve to dissipate thermal energy from a heated liquid circulating therethrough to the ambient environment. For example, in a datacenter or similar facility, the dry cooling units **110, 210** operate to receive heated liquid from the respective rack-mounted processing assemblies **120A-120N, 220A-220N** and extract the thermal energy from the heated liquid by dissipating the energy into the ambient environment via the respective at least one fan assemblies **110A, 210A** to thereby re-cool the heated liquid. The dry cooling units **110, 210** then operate to supply the re-cooled liquid back to the respective rack-mounted processing assemblies **120A-120N, 220A-220N.**

As shown, each of the dry cooling units **110, 210** respectively include at least one heat exchanger **110B, 210B** and at least one fan assembly **110A, 210A.** The heat exchangers **110B, 210B** may manifest a variety of configurations, such as, air-to-liquid heat exchanger *etc*., and may further include evaporating or cooling pads. For purposes of the instant disclosure, the exact configuration of the dry cooling units **110, 210** and heat exchangers **110B, 210B** is not limiting, as various configurations could be employed without departing from the concepts of the instant disclosure.

As also shown, the forward liquid distribution circuits **115, 215** incorporate at least one pump **112A, 212A.** In the depicted embodiment, the forward liquid distribution circuits **115, 215** respectively employ two pumps **112A, 112B** and **212A, 212B,** each respective set being arranged in a parallel configuration to maintain the flow rate of the cooling/re-cooled liquid supplied to the processing assemblies **120A-120N, 220A-220N** at an adequate level.

The forward liquid distribution circuits **115, 215** also incorporate respective forward "smart" control valves **119A, 219A.** For purposes of the instant disclosure, the term "smart" valve refers to a valve that is pressure-independent, temperature-responsive, incorporates a differential pressure regulator to automatically adjust to system pressure changes as well as shut down given certain operational conditions. Such smart valves may comprise PICVs, ABQMs, other functionally similar valves, or combinations of valves, such as a solenoid valve combined with a control valve. In this implementation, the smart control valves **119A, 219A** are configured to sense and adjust the flow of the cooling/re-cooled liquid supplied to the processing assemblies **120A-120N, 220A-220N.** As discussed in greater detail below, the forward smart control valves **119A, 219A** are also communicatively coupled to respective control module panels **101, 201** to provide notification of a liquid flow or component failure, such as, for example mechanical/electrical failure of pumps or fan assemblies.

The heated liquid from the rack-mounted processing assemblies **120A-120N, 220A-220N** is returned back to the dry cooling units **110, 210** for re-cooling via the respective return liquid distribution circuits **125, 225.** The return liquid distribution circuits **125, 225** also incorporate return smart control valves **119B, 219B** that are configured to sense and adjust the flow of the heated liquid returned back to the dry cooling units **110, 210.**

As depicted, the dry cooling units **110, 210** supply the cooling/re-cooled liquid to the respective rack-mounted processing assemblies **120A-120N, 220A-220N** at a nominal temperature T and the heated liquid returned to the dry cooling units **110, 210** is at a nominal temperature T + ΔT, where ΔT represents the temperature differential between the cooling/re-cooled liquid and the heated liquid.

The liquid cooling arrangements **100, 200** of system **10** respectively include a plurality of rack-mounted processing assemblies **120A-120N, 220A-220N** which receive the supplied cooling/re-cooled liquid via the corresponding forward liquid distribution circuits **115, 215** to internally channel the cooling liquid to the heat-generating processing components (*e.g*., water circulated through water blocks), and convey the heated liquid from the heat-generating processing components to the return liquid distribution circuit **125, 225.**

The rack-mounted processing assemblies **120A-120N, 220A-220N** may or may not be configured with similar heat-generating processing components. As such, each of the rack-mounted processing assemblies **120A-120N, 220A-220N** may have different temperature and flow rate requirements for proper operations.

It will be appreciated that, while the rack-mounted processing assemblies **120A-120N, 220A-220N** are depicted to be arranged in a parallel configuration, it is not meant to be limiting, as the processing assemblies **120A-120N, 220A-220N** may also be arranged in a serial or combined parallel and serial configuration without departing from the concepts of the instant disclosure.

As shown, each of the rack-mounted processing assemblies **120A-120N, 220A-220N** is fluidly-coupled to a smart valve **122A-122N, 222A-222N** that dynamically controls the flow rate of the corresponding processing assembly **120A-120N, 220A-220N** based on detected liquid temperatures.

Along the forward liquid distribution circuits **115, 215,** liquid cooling arrangements 100, 200 also incorporate temperature sensors **126, 226** for measuring the temperature of the supplied cooling liquid Tc, flow pressure sensors **127, 227** for measuring the pressure of the flow of the supplied liquid P, and volume sensors **128, 228** for measuring the flow rate of the supplied cooling liquid Vc.

For the return liquid distribution circuits **125, 225,** liquid cooling arrangements **100, 200** also incorporate temperature sensors **125, 225** for measuring the temperature of the return heated liquid T_{H}.

The liquid cooling arrangements **100, 200** additionally incorporate corresponding bypass control valves **140, 240** that are fluidly-coupled to the auxiliary liquid feed circuits **117, 217** for supplementing the return liquid flow back to the dry cooling units **110, 210.**

The system **10** further employs a liquid sharing support circuit **160** to enable the sharing/transfer of liquid cooling components/resources of the liquid cooling arrangements **100, 200** in the event of crucial flow component failures of either of the liquid cooling arrangements **100, 200.** Such crucial flow component failures may include, for example, pump **112A, 112B, 212A, 212B** failures and/or dry cooling unit **110, 210** failures.

In particular, the liquid sharing support circuit **160** implements a first switchover control valve or solenoid valve **145** that is fluidly coupled to the forward liquid distribution circuits **115, 215** of both the first and second cooling arrangements **100, 200.** The fluid coupling point of the first switchover control valve **145** to each of the forward liquid distribution circuits **115, 215** is proximately disposed downstream from the forward smart control valves **119A, 219A** and upstream from the respective processing assemblies **120A-120N, 220A-220N.**

Commensurately, the liquid sharing support circuit **160** implements a second switchover control valve or solenoid valve **245** that is fluidly coupled to the return liquid distribution circuits **125, 225** of both first and second cooling arrangements **100, 200.** The fluid coupling point of the second switchover control valve **245** to each of the return liquid distribution circuits **125, 225** is proximately disposed downstream from the respective processing assemblies **120A-120N, 220A-220N** and upstream from the return smart control valves **119B, 219B.**

As noted above, each of the liquid cooling arrangements **100, 200** also respectively incorporate control module panels **101, 201** that are communicatively-coupled to various components as well as flow, pressure, and temperature sensors. That is, for various nonlimiting embodiments, the control module panels **101, 201** are configured to receive data from the temperature sensors **126, 226, 130, 230,** pressure sensors **127, 227,** volume sensors **128, 228,** and smart control valves **119A, 219A,** process the data, and provide notifications to operators to address failure and maintenance issues.

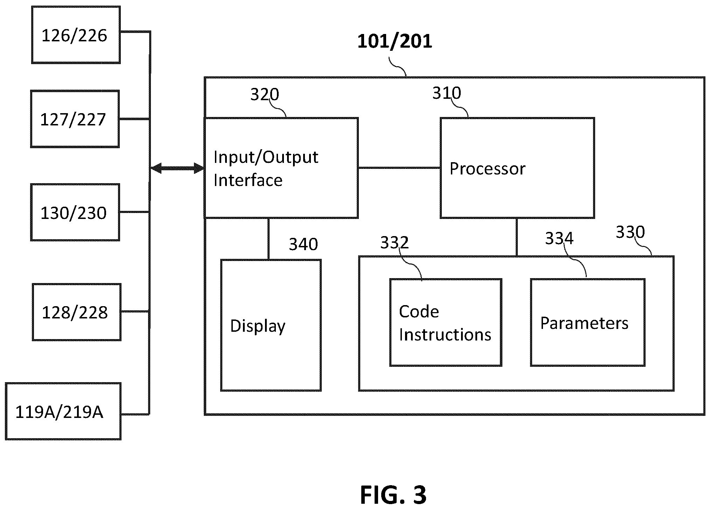

FIG. 3 illustrates a high-level functional block diagram of a representative control module panel **101/201** of a datacenter liquid cooling system, in accordance with the nonlimiting embodiments of the present technology. As shown, the control module panel **101/201** comprises a processor or a plurality of cooperating processors (represented as a processor **310** for simplicity), a memory device or a plurality of memory devices (represented as a memory device **330** for simplicity), and an input/output interface **320** (or separate input and output interfaces) allowing the control module panel **101/201** to communicate with certain components of the datacenter liquid cooling system **10.** The processor **310** is operatively connected to the memory device **330** and to the input/output interface **320.** The memory device **330** includes a storage for storing parameters **334,** including for example and without limitation the above-mentioned pre-determined conductivity thresholds. The memory device **330** may comprise a non-transitory computer-readable medium for storing code instructions **332** that are executable by the processor **310** to allow the control module panel **101/201** to perform the various tasks allocated to the controller control module panel **101/201.**

Moreover, the controller control module panel **101/201** is operatively connected, via the input/output interface **320,** to the components of the datacenter liquid cooling system **10,** such as, temperature sensors **126, 226, 130, 230,** pressure sensors **127, 227,** volume sensors **128, 228,** and smart control valves **119A, 219A.** In addition, the controller control module panel **101/201** is operatively connected to a display device **340** configured to provide alerts and notifications to operators via visual and/or auditory means.

Returning to FIG. 1, control module panels **101, 201** are also communicatively-coupled to the forward smart control valves **119A, 219A** of the corresponding forward liquid distribution circuits **115, 215** for both of the first and second cooling arrangements **100, 200.** Accordingly, in the event that either of the forward smart control valves **119A/219A** detects any type of liquid flow anomaly along one of the corresponding forward liquid distribution circuits **115/215,** the relevant forward smart control valve **119A/219A** provides information regarding the same to the corresponding control module panels **101/201.**

Accordingly, responsive to notifications by the relevant forward smart control valve **119A/219A** and/or the received data from the relevant temperature sensors **126, 226, 130, 230,** pressure sensors **127, 227,** and volume sensors **128, 228** of a detected liquid flow anomaly, the corresponding control module panel **101/201** issues an alert message to an operator indicating that one of the forward smart control valves **119A/219A** has detected a cooling liquid flow anomaly that may be due to a component failure issues along a corresponding forward liquid distribution circuit **115/215.**

In some embodiments, responsive to a detected issue, the operator may then activate the first switchover control/solenoid valve **145** to open and route a suitable portion of the cooling liquid flow from the operational (*i.e*., non-failing) forward liquid distribution circuit **115/215** to the processing assemblies **120A-120N/220A-220N** of the failing forward liquid distribution circuit **115/215.**

In other embodiments, responsive to a detected issue, the corresponding control module panel **101/201** may automatically activate the first switchover control/solenoid valve **145** to open and direct a suitable portion of the cooling liquid flow from the operational (*i.e.*, non-failing) forward liquid distribution circuit **115/215** to the processing assemblies **120A-120N/220A-220N** of the failing forward liquid distribution circuit **115/215.**

Correspondingly, the operator may also activate the second switchover control valve/solenoid valve **245** to open and route a suitable portion of the heated liquid flow from the processing assemblies **120A-120N/220A-220N** of the failing return liquid distribution circuit **125/225** to the operational return liquid distribution circuit **125/225** for re-cooling by the dry cooling unit **110/210** pertaining to the operational return liquid distribution circuit **125/225.**

As noted above, because the forward smart control valves **119A/219A** are configured to dynamically adjust to system pressure changes, the smart control valves **119A/219A** are capable of providing acceptable cooling liquid flow to the processing assemblies **120A-120N/220A-220N** of both, the operational forward liquid distribution circuit and the failing forward liquid distribution circuit **115/215.**

In this manner, the presented datacenter liquid cooling system **10** having sharing support capability via the liquid sharing support circuit **160** and associated switchover control/solenoid valve **145, 245** operates to minimize the damaging effects due to crucial flow component failures of a single liquid cooling arrangement by sharing liquid cooling components/resources of other operational liquid cooling arrangements as well as provide for routine or planned maintenance.

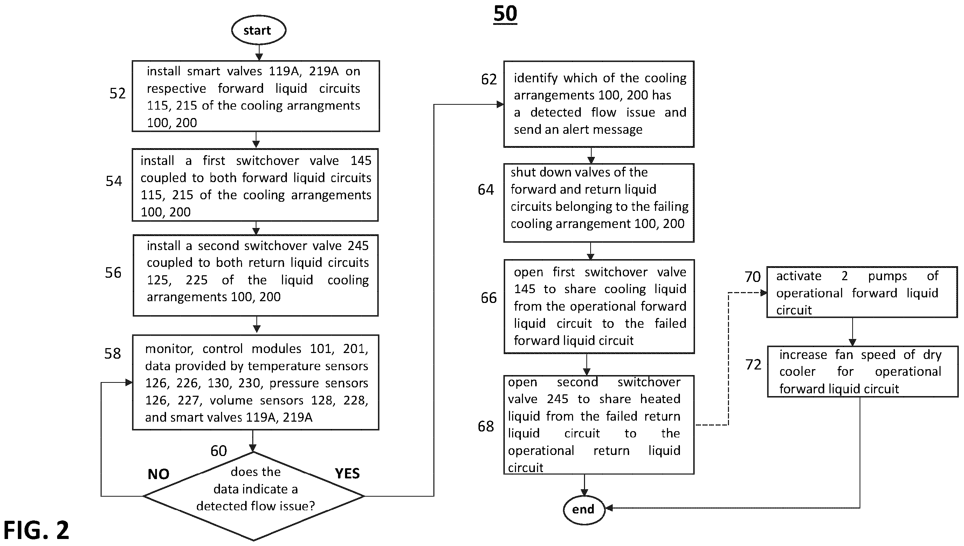

With this said, FIG. 2 illustrates a flow diagram of a datacenter liquid cooling resource sharing process **50** in the event of component failure, in accordance with the nonlimiting embodiments of the present technology. Process **50** or portions thereof may be executed by relevant components, such as, for example, smart control valves, switchover/solenoid valves or may equally be executed by the control module panels **101** and/or **201** of the corresponding first and second cooling arrangements **100, 200.** For purposes of the instant disclosure, the exact entity or entities executing process **50** is not limiting with regard to the inventive concepts presented herein.

As shown, at task block **52,** process **50** provides for the installation of forward smart control/solenoid valves **119A, 219A** onto each of the respective forward cooling liquid distribution circuits **115, 215.** At task block **54,** process **50** provides for the installation of the first switchover/ABQM/solenoid valve **145** that is to be fluidly coupled to both forward cooling liquid distribution circuits **115, 215** and, at task block **56,** for the installation of the second switchover/ABQM/solenoid valve **245 that** is to be fluidly coupled to both return heated liquid distribution circuits **125, 225.**

At task block **58,** the control modules **101, 201** monitor the data reported by temperature sensors **126, 226, 130, 230,** pressure sensors **126, 227,** volume sensors **128, 228,** and smart valves **119A, 219A.** Then at decision block **60,** process **50** determines whether the reported data indicates a detection of a liquid flow anomaly or failure. If no liquid flow anomalies or failures are detected, process **50** reverts back to task block **58** to continue monitoring the data reported by the temperature sensors **126, 226, 130, 230,** pressure sensors **126, 227,** volume sensors **128, 228,** and smart valves **119A, 219A.**

However, if the reported data to the control modules **101, 201** indicates a liquid flow anomaly/failure, at task block **62,** process **50** identifies which of the first or second cooling arrangements **100, 200** has experienced a liquid flow issue and sends an alert message via the control modules **101, 201.**

Based on the alert message, at task block **64,** process **50** directs the shut down of the respective forward cooling liquid distribution circuit **115, 215** and return heated liquid distribution circuit **125, 225** of the first or second cooling arrangements **100, 200** identified as experiencing liquid flow issues. The shutting down of the identified liquid distribution circuits includes closing the related valves **119A, 119B** or valves **219A, 219B.** The closing of the related valves **119A, 119B, 219A, 219B** may be conducted manually by an operator or automatically based on executable instructions issued by the control modules **101, 201** directly to the related valves **119A, 119B, 219A, 219B.**

In turn, at task block **66,** process **50** directs the opening of the first switchover valve **145** to route a suitable portion of the cooling liquid flow from the operational forward liquid distribution circuit **115/215** to the processing assemblies **120A-120N/220A-220N** of the identified failing forward liquid distribution circuit **115/215.** This allows for the sharing of the cooling liquid flow from the operational forward liquid distribution circuit **115, 215** to the identified failing forward liquid circuit.

Commensurately, at task block **68,** process **50** directs the opening of the second switchover valve **245** to route a suitable portion of the heated liquid flow from the processing assemblies **120A-120N/220A-220N** of the identified failing return liquid distribution circuit **125/225** to the operational return liquid distribution circuit **125/225** for re-cooling by the dry cooling unit **110/210.** Again, this allows for the sharing of the heated liquid flow from the identified failing forward liquid circuit to the operational forward liquid distribution circuit **115, 215.**

In various nonlimiting embodiments, process **50** terminates after the first and second switchover valves **145, 245** are opened to share resources between an operational cooling arrangement and an identified failing cooling arrangement **100, 200.** However, in certain nonlimiting embodiments, process **50** may continue to task block **70** to activate both pumps **112A, 112B** or **212A, 212B** of the operational cooling arrangement to maximize the cooling liquid flow to the identified failing cooling arrangement **100, 200.**

Additionally, in certain nonlimiting embodiments, process **50** may further continue to task block **72** to increase the speed of the fan assemblies **110A, 210A** of the dry cooling unit **110, 210** pertaining to the operational cooling arrangement to further maximize the cooling liquid flow to the identified failing cooling arrangement **100, 200.**

In this manner, the presented liquid cooling resource sharing process **50** operates to provide liquid support capability to failing liquid cooling arrangements by sharing liquid cooling components/resources of other operational liquid cooling arrangements.

While the above-described implementations have been described and shown with reference to particular steps performed in a particular order, it will be understood that these steps may be combined, sub-divided, or re-ordered without departing from the teachings of the present technology. At least some of the steps may be executed in parallel or in series. Accordingly, the order and grouping of the steps is not a limitation of the present technology.

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

## Claims

1. A datacenter liquid cooling system (10) for cooling rack-mounted processing assemblies (120A-120N, 220A-220N), comprising:
a first cooling arrangement (100) comprising:
a first dry cooling unit (110) configured to supply a cooling liquid to the rack-mounted processing assemblies (120A-120N) and receive a heated liquid from the rack-mounted processing assemblies (120A-120N),
a first forward liquid distribution circuit (115) including a temperature sensor (126), at least one first pump (112A, 112B), a pump pressure sensor (127), a liquid flow volume sensor (128), and a forward smart control or solenoid valve (119A) to convey the cooling liquid from the dry cooling unit to the rack-mounted processing assemblies (120A-120N),
a first return liquid distribution circuit (125) including a return smart control solenoid valve (119B) to convey the heated liquid from the rack-mounted processing assemblies (120A-120N) back to the first dry cooling unit (110) and a temperature sensor (130),
a first control module panel (101) communicatively-coupled to the temperature sensor (126), pump pressure sensor (127), liquid flow volume sensor (128), temperature sensor (130), and forward smart control or solenoid valve (119A) to receive data therefrom,
each of the rack-mounted data processing assemblies (120A-120N) comprising at least one heat-generating electronic processing element and at least one liquid cooling block arranged to be in respective thermal contact with the at least one heat-generating electronic processing element and fluidly-coupled to the first forward liquid distribution circuit (115) and smart flow valves (122A-122N) respectively arranged to be fluidly-coupled to the at least one liquid cooling block of the corresponding rack-mounted data processing assembly, and
a second cooling arrangement (200) comprising:
a second dry cooling unit (210) configured to supply a cooling liquid to the rack-mounted processing assemblies (220A-220N) and receive a heated liquid from the rack-mounted processing assemblies (220A-220N),
a second forward liquid distribution circuit (215) including a temperature sensor (226), at least one second pump (212A, 212B), a pump pressure sensor (227), a liquid flow volume sensor (228), and a forward smart control or solenoid valve (219A),
a second return liquid distribution circuit (125) including a return smart control solenoid valve (219B) to convey the heated liquid from the rack-mounted processing assemblies (220A-220N) back to the first dry cooling unit (210) and a temperature sensor (230),
a second control module panel (201) communicatively-coupled to the temperature sensor (226), pump pressure sensor (227), liquid flow volume sensor (228), temperature sensor (230), and forward smart control or solenoid valve (219A) to receive data therefrom,
each of the rack-mounted data processing assemblies (220A-220N) comprising at least one heat-generating electronic processing element and at least one liquid cooling block arranged to be in respective thermal contact with the at least one heat-generating electronic processing element and fluidly-coupled to the first liquid distribution circuit (215) and smart control valves (222A-222N) respectively arranged to be fluidly-coupled to the at least one liquid cooling block of the corresponding rack-mounted data processing assembly;
a liquid sharing support circuit (160) comprising:
a first switchover control valve (145) fluidly coupled to the forward liquid distribution circuits (115, 215) of the corresponding first and second cooling arrangements (100, 200) that convey the cooling liquid from the dry cooling units (110, 210),
a second switchover control valve (245) fluidly coupled to the return liquid distribution circuits (125, 225) of the corresponding first and second cooling arrangements (100, 200) that convey the heated liquid back to the dry cooling units (110, 210); and
wherein, in response to receiving data indicating a detected liquid flow failure, the first or second control module panels (101, 201) operate to:
identify which of the forward liquid cooling circuits (115/215) has experienced a detected liquid flow failure,
shut down the respective forward cooling liquid distribution circuit (115, 215) and return heated liquid distribution circuit (125, 225) of the identified flow failing first or second cooling arrangements (100, 200),
open the first switchover valve (145) to route a suitable portion of the cooling liquid flow from the operational forward liquid distribution circuit (115/215) to the identified failing forward liquid distribution circuit (115/215), and
open the second switchover valve (245) to route a suitable portion of the heated liquid flow from the identified failing return liquid distribution circuit (125/225) to the operational return liquid distribution circuit (125/225).

2. The datacenter liquid cooling system (10) of claim 1, wherein the first switchover valve (145) is fluidly coupled to the forward liquid distribution circuits (115, 215) at respective coupling points that are proximately disposed downstream from the forward smart control valves (119A, 219A) and upstream from the respective processing assemblies (120A-120N, 220A-220N).

3. The datacenter liquid cooling system (10) of claims 1 or 2, the second switchover valve (245) is fluidly coupled to the return liquid distribution circuits (125, 225) at respective coupling points that are proximately disposed downstream from the respective processing assemblies (120A-120N, 220A-220N) and upstream from the return smart control valves (119B, 219B).

4. The datacenter liquid cooling system (10) of anyone of claims 1 to 3, wherein each of the control panel modules (101, 201) are configured to monitor the received data from the respective the temperature sensors, pump pressure sensors, volume sensors, and forward smart control/solenoid valves to determine a detected liquid flow failure and issue alerts regarding corresponding detected liquid flow failures of a cooling arrangement (100, 200).

5. The datacenter liquid cooling system (10) of anyone of claims 1 to 4, wherein the shutting down of the identified failing liquid distribution circuits includes closing the valves (119A, 119B, 219A, 219B).

6. The datacenter liquid cooling system (10) of anyone of claims 1 to 5, wherein the closing of the identified failing liquid distribution circuits valves (119A, 119B, 219A, 219B) and the opening of the first and second switchover valves (145, 245) are automatically initiated based on executable instructions provided by the control panel modules (101, 201).

7. The datacenter liquid cooling system (10) of anyone of claims 1 to 5, wherein the closing of the identified failing liquid distribution circuits valves (119A, 119B, 219A, 219B) and the opening of the first and second switchover valves (145, 245) are conducted manually by an operator in response to the issue alerts provided by the control panel modules (101, 201).

8. The datacenter liquid cooling system (10) of anyone of claims 1 to 7 wherein, after opening the first and second switchover valves (145, 245), the control panel modules (101, 201) operate to activate both pumps (112A, 112B or 212A, 212B) of the operational forward liquid circuit and/or activate evaporative dry cooling to maximize liquid cooling flow routed to the identified failing cooling arrangement (100, 200).

9. The datacenter liquid cooling system (10) of anyone of claims 1 to 8 wherein, after opening the first and second switchover valves (145, 245), the control panel modules (101, 201) operate to increase the speed of the fan assemblies (110A, 210A) of the dry cooling unit (110, 210) pertaining to the operational cooling arrangement to maximize the cooling liquid flow routed to the identified failing cooling arrangement (100, 200).

10. A liquid cooling method (50) for a datacenter system (10) in which:
the datacenter system (10) includes:
a first dry cooling unit (110) configured to supply a cooling liquid to the rack-mounted processing assemblies (120A-120N) and receive a heated liquid from the rack-mounted processing assemblies (120A-120N), a first forward liquid distribution circuit (115) including a temperature sensor (126), at least one first pump (112A, 112B), a pump pressure sensor (127), a liquid flow volume sensor (128), and a forward smart control or solenoid valve (119A) to convey the cooling liquid from the dry cooling unit to the rack-mounted processing assemblies (120A-120N), a first return liquid distribution circuit (125) including a return smart control solenoid valve (119B) to convey the heated liquid from the rack-mounted processing assemblies (120A-120N) back to the first dry cooling unit (110) and a temperature sensor (130), a first control module panel (101) communicatively-coupled to the temperature sensor (126), pump pressure sensor (127), liquid flow volume sensor (128), temperature sensor (130), and forward smart control or solenoid valve (119A) to receive data therefrom, each of the rack-mounted data processing assemblies (120A-120N) comprising at least one heat-generating electronic processing element and at least one liquid cooling block arranged to be in respective thermal contact with the at least one heat-generating electronic processing element and fluidly-coupled to the first forward liquid distribution circuit (115) and smart flow valves (122A-122N) respectively arranged to be fluidly-coupled to the at least one liquid cooling block of the corresponding rack-mounted data processing assembly, and
a second cooling arrangement (200) comprising a second dry cooling unit (210) configured to supply a cooling liquid to the rack-mounted processing assemblies (220A-220N) and receive a heated liquid from the rack-mounted processing assemblies (220A-220N), a second forward liquid distribution circuit (215) including a temperature sensor (226), at least one second pump (212A, 212B), a pump pressure sensor (227), a liquid flow volume sensor (228), and a forward smart control or solenoid valve (219A), a second return liquid distribution circuit (125) including a return smart control solenoid valve (219B) to convey the heated liquid from the rack-mounted processing assemblies (220A-220N) back to the first dry cooling unit (210) and a temperature sensor (230), a second control module panel (201) communicatively-coupled to the temperature sensor (226), pump pressure sensor (227), liquid flow volume sensor (228), temperature sensor (230), and forward smart control or solenoid valve (219A) to receive data therefrom, each of the rack-mounted data processing assemblies (220A-220N) comprising at least one heat-generating electronic processing element and at least one liquid cooling block arranged to be in respective thermal contact with the at least one heat-generating electronic processing element and fluidly-coupled to the first liquid distribution circuit (215) and smart control valves (222A-222N) respectively arranged to be fluidly-coupled to the at least one liquid cooling block of the corresponding rack-mounted data processing assembly
the liquid cooling method (50) comprising:
providing a liquid sharing support circuit (160) that includes:
providing a first switchover control valve (145) fluidly coupled to the forward liquid distribution circuits (115, 215) of the corresponding first and second cooling arrangements (100, 200) that convey the cooling liquid from the dry cooling units (110, 210), and
providing a second switchover control valve (245) fluidly coupled to the return liquid distribution circuits (125, 225) of the corresponding first and second cooling arrangements (100, 200) that convey the heated liquid back to the dry cooling units (110, 210);
wherein, in response to receiving data indicating a detected liquid flow failure, the first or second control module panels (101, 201):
identifying which of the forward liquid cooling circuits (115/215) has experienced a detected liquid flow failure,
shutting down the respective forward cooling liquid distribution circuit (115, 215) and return heated liquid distribution circuit (125, 225) of the identified flow failing first or second cooling arrangements (100, 200),
opening the first switchover valve (145) to route a suitable portion of the cooling liquid flow from the operational forward liquid distribution circuit (115/215) to the identified failing forward liquid distribution circuit (115/215), and
opening the second switchover valve (245) to route a suitable portion of the heated liquid flow from the identified failing return liquid distribution circuit (125/225) to the operational return liquid distribution circuit (125/225).

11. The liquid cooling method (50) of claim 10, wherein each of the control panel modules (101, 201) are configured to monitor the received data from the respective the temperature sensors, pump pressure sensors, volume sensors, and forward smart control/solenoid valves to determine a detected liquid flow failure and issue alerts regarding corresponding detected liquid flow failures of a cooling arrangement (100, 200).

12. The liquid cooling method (50) of claims 10 or 11 wherein, the closing of the identified failing liquid distribution circuits valves (119A, 119B, 219A, 219B) and the opening of the first and second switchover valves (145, 245) are automatically initiated based on executable instructions provided by the control panel modules (101, 201).

13. The liquid cooling method (50) of anyone of claims 10 to 11 wherein the closing of the identified failing liquid distribution circuits valves (119A, 119B, 219A, 219B) and the opening of the first and second switchover valves (145, 245) are conducted manually by an operator in response to the issue alerts provided by the control panel modules (101, 201)..

14. The liquid cooling method (50) of anyone of claims 10 to 13 wherein, after opening the first and second switchover valves (145, 245), the control panel modules (101, 201) operate to activate both pumps (112A, 112B or 212A, 212B) of the operational forward liquid circuit to maximize liquid cooling flow routed to the identified failing cooling arrangement (100, 200).

15. The liquid cooling method (50) of anyone of claims 10 to 14, wherein after opening the first and second switchover valves (145, 245), the control panel modules (101, 201) operate to increase the speed of the fan assemblies (110A, 210A) of the dry cooling unit (110, 210) pertaining to the operational cooling arrangement to maximize the cooling liquid flow routed to the identified failing cooling arrangement (100, 200).

## Amended claims

### Amended claims in accordance with Rule 137(2) EPC.

1. A datacenter liquid cooling system (10) for cooling rack-mounted processing assemblies (120A-120N, 220A-220N), comprising:
a first cooling arrangement (100) comprising:
a first dry cooling unit (110) configured to supply a cooling liquid to the rack-mounted processing assemblies (120A-120N) and receive a heated liquid from the rack-mounted processing assemblies (120A-120N),
a first forward liquid distribution circuit (115) including a temperature sensor (126), at least one first pump (112A, 112B), a pump pressure sensor (127), a liquid flow volume sensor (128), and a forward smart control or solenoid valve (119A) to convey the cooling liquid from the dry cooling unit to the rack-mounted processing assemblies (120A-120N),
a first return liquid distribution circuit (125) including a return smart control solenoid valve (119B) to convey the heated liquid from the rack-mounted processing assemblies (120A-120N) back to the first dry cooling unit (110) and a temperature sensor (130),
a first control module panel (101) communicatively-coupled to the temperature sensor (126), pump pressure sensor (127), liquid flow volume sensor (128), temperature sensor (130), and forward smart control or solenoid valve (119A) to receive data therefrom,
each of the rack-mounted data processing assemblies (120A-120N) comprising at least one heat-generating electronic processing element and at least one liquid cooling block arranged to be in respective thermal contact with the at least one heat-generating electronic processing element and fluidly-coupled to the first forward liquid distribution circuit (115) and smart flow valves (122A-122N) respectively arranged to be fluidly-coupled to the at least one liquid cooling block of the corresponding rack-mounted data processing assembly, and
a second cooling arrangement (200) comprising:
a second dry cooling unit (210) configured to supply a cooling liquid to the rack-mounted processing assemblies (220A-220N) and receive a heated liquid from the rack-mounted processing assemblies (220A-220N),
a second forward liquid distribution circuit (215) including a temperature sensor (226), at least one second pump (212A, 212B), a pump pressure sensor (227), a liquid flow volume sensor (228), and a forward smart control or solenoid valve (219A),
a second return liquid distribution circuit (125) including a return smart control solenoid valve (219B) to convey the heated liquid from the rack-mounted processing assemblies (220A-220N) back to the first dry cooling unit (210) and a temperature sensor (230),
a second control module panel (201) communicatively-coupled to the temperature sensor (226), pump pressure sensor (227), liquid flow volume sensor (228), temperature sensor (230), and forward smart control or solenoid valve (219A) to receive data therefrom,
each of the rack-mounted data processing assemblies (220A-220N) comprising at least one heat-generating electronic processing element and at least one liquid cooling block arranged to be in respective thermal contact with the at least one heat-generating electronic processing element and fluidly-coupled to the first liquid distribution circuit (215) and smart control valves (222A-222N) respectively arranged to be fluidly-coupled to the at least one liquid cooling block of the corresponding rack-mounted data processing assembly;
a liquid sharing support circuit (160) comprising:
a first switchover control valve (145) fluidly coupled to the forward liquid distribution circuits (115, 215) of the corresponding first and second cooling arrangements (100, 200) that convey the cooling liquid from the dry cooling units (110, 210), the first switchover valve (145) is fluidly coupled to the forward liquid distribution circuits (115, 215) at respective coupling points that are proximately disposed downstream from the forward smart control valves (119A, 219A) and upstream from the respective processing assemblies (120A-120N, 220A-220N),
a second switchover control valve (245) fluidly coupled to the return liquid distribution circuits (125, 225) of the corresponding first and second cooling arrangements (100, 200) that convey the heated liquid back to the dry cooling units (110, 210), the second switchover valve (245) is fluidly coupled to the return liquid distribution circuits (125, 225) at respective coupling points that are proximately disposed downstream from the respective processing assemblies (120A-120N, 220A-220N) and upstream from the return smart control valves (119B, 219B); and
wherein, in response to receiving data indicating a detected liquid flow failure, the first or second control module panels (101, 201) operate to:
identify which of the forward liquid cooling circuits (115/215) has experienced a detected liquid flow failure,
shut down the respective forward cooling liquid distribution circuit (115, 215) and return heated liquid distribution circuit (125, 225) of the identified flow failing first or second cooling arrangements (100, 200),
open the first switchover valve (145) to route a suitable portion of the cooling liquid flow from the operational forward liquid distribution circuit (115/215) to the identified failing forward liquid distribution circuit (115/215), and
open the second switchover valve (245) to route a suitable portion of the heated liquid flow from the identified failing return liquid distribution circuit (125/225) to the operational return liquid distribution circuit (125/225).

2. The datacenter liquid cooling system (10) of claim 1, wherein each of the control panel modules (101, 201) are configured to monitor the received data from the respective the temperature sensors, pump pressure sensors, volume sensors, and forward smart control/solenoid valves to determine a detected liquid flow failure and issue alerts regarding corresponding detected liquid flow failures of a cooling arrangement (100, 200).

3. The datacenter liquid cooling system (10) of anyone of claims 1 to 2,wherein the shutting down of the identified failing liquid distribution circuits includes closing the valves (119A, 119B, 219A, 219B).

4. The datacenter liquid cooling system (10) of anyone of claims 1 to 3, wherein the closing of the identified failing liquid distribution circuits valves (119A, 119B, 219A, 219B) and the opening of the first and second switchover valves (145, 245) are automatically initiated based on executable instructions provided by the control panel modules (101, 201).

5. The datacenter liquid cooling system (10) of anyone of claims 1 to 4, wherein the closing of the identified failing liquid distribution circuits valves (119A, 119B, 219A, 219B) and the opening of the first and second switchover valves (145, 245) are conducted manually by an operator in response to the issue alerts provided by the control panel modules (101, 201).

6. The datacenter liquid cooling system (10) of anyone of claims 1 to 5 wherein, after opening the first and second switchover valves (145, 245), the control panel modules (101, 201) operate to activate both pumps (112A, 112B or 212A, 212B) of the operational forward liquid circuit and/or activate evaporative dry cooling to maximize liquid cooling flow routed to the identified failing cooling arrangement (100, 200).

7. The datacenter liquid cooling system (10) of anyone of claims 1 to 6 wherein, after opening the first and second switchover valves (145, 245), the control panel modules (101, 201) operate to increase the speed of the fan assemblies (110A, 210A) of the dry cooling unit (110, 210) pertaining to the operational cooling arrangement to maximize the cooling liquid flow routed to the identified failing cooling arrangement (100, 200).

8. A liquid cooling method (50) for a datacenter system (10) in which:
the datacenter system (10) includes:
a first dry cooling unit (110) configured to supply a cooling liquid to the rack-mounted processing assemblies (120A-120N) and receive a heated liquid from the rack-mounted processing assemblies (120A-120N), a first forward liquid distribution circuit (115) including a temperature sensor (126), at least one first pump (112A, 112B), a pump pressure sensor (127), a liquid flow volume sensor (128), and a forward smart control or solenoid valve (119A) to convey the cooling liquid from the dry cooling unit to the rack-mounted processing assemblies (120A-120N), a first return liquid distribution circuit (125) including a return smart control solenoid valve (119B) to convey the heated liquid from the rack-mounted processing assemblies (120A-120N) back to the first dry cooling unit (110) and a temperature sensor (130), a first control module panel (101) communicatively-coupled to the temperature sensor (126), pump pressure sensor (127), liquid flow volume sensor (128), temperature sensor (130), and forward smart control or solenoid valve (119A) to receive data therefrom, each of the rack-mounted data processing assemblies (120A-120N) comprising at least one heat-generating electronic processing element and at least one liquid cooling block arranged to be in respective thermal contact with the at least one heat-generating electronic processing element and fluidly-coupled to the first forward liquid distribution circuit (115) and smart flow valves (122A-122N) respectively arranged to be fluidly-coupled to the at least one liquid cooling block of the corresponding rack-mounted data processing assembly, and
a second cooling arrangement (200) comprising a second dry cooling unit (210) configured to supply a cooling liquid to the rack-mounted processing assemblies (220A-220N) and receive a heated liquid from the rack-mounted processing assemblies (220A-220N), a second forward liquid distribution circuit (215) including a temperature sensor (226), at least one second pump (212A, 212B), a pump pressure sensor (227), a liquid flow volume sensor (228), and a forward smart control or solenoid valve (219A), a second return liquid distribution circuit (125) including a return smart control solenoid valve (219B) to convey the heated liquid from the rack-mounted processing assemblies (220A-220N) back to the first dry cooling unit (210) and a temperature sensor (230), a second control module panel (201) communicatively-coupled to the temperature sensor (226), pump pressure sensor (227), liquid flow volume sensor (228), temperature sensor (230), and forward smart control or solenoid valve (219A) to receive data therefrom, each of the rack-mounted data processing assemblies (220A-220N) comprising at least one heat-generating electronic processing element and at least one liquid cooling block arranged to be in respective thermal contact with the at least one heat-generating electronic processing element and fluidly-coupled to the first liquid distribution circuit (215) and smart control valves (222A-222N) respectively arranged to be fluidly-coupled to the at least one liquid cooling block of the corresponding rack-mounted data processing assembly
the liquid cooling method (50) comprising:
providing a liquid sharing support circuit (160) that includes:
providing a first switchover control valve (145) fluidly coupled to the forward liquid distribution circuits (115, 215) of the corresponding first and second cooling arrangements (100, 200) that convey the cooling liquid from the dry cooling units (110, 210), the first switchover valve (145) is fluidly coupled to the forward liquid distribution circuits (115, 215) at respective coupling points that are proximately disposed downstream from the forward smart control valves (119A, 219A) and upstream from the respective processing assemblies (120A-120N, 220A-220N), and
providing a second switchover control valve (245) fluidly coupled to the return liquid distribution circuits (125, 225) of the corresponding first and second cooling arrangements (100, 200) that convey the heated liquid back to the dry cooling units (110, 210), the second switchover valve (245) is fluidly coupled to the return liquid distribution circuits (125, 225) at respective coupling points that are proximately disposed downstream from the respective processing assemblies (120A-120N, 220A-220N) and upstream from the return smart control valves (119B, 219B);
wherein, in response to receiving data indicating a detected liquid flow failure, the first or second control module panels (101, 201):
identifying which of the forward liquid cooling circuits (115/215) has experienced a detected liquid flow failure,
shutting down the respective forward cooling liquid distribution circuit (115, 215) and return heated liquid distribution circuit (125, 225) of the identified flow failing first or second cooling arrangements (100, 200),
opening the first switchover valve (145) to route a suitable portion of the cooling liquid flow from the operational forward liquid distribution circuit (115/215) to the identified failing forward liquid distribution circuit (115/215), and
opening the second switchover valve (245) to route a suitable portion of the heated liquid flow from the identified failing return liquid distribution circuit (125/225) to the operational return liquid distribution circuit (125/225).

9. The liquid cooling method (50) of claim 8, wherein each of the control panel modules (101, 201) are configured to monitor the received data from the respective the temperature sensors, pump pressure sensors, volume sensors, and forward smart control/solenoid valves to determine a detected liquid flow failure and issue alerts regarding corresponding detected liquid flow failures of a cooling arrangement (100, 200).

10. The liquid cooling method (50) of claims 8 or 9 wherein, the closing of the identified failing liquid distribution circuits valves (119A, 119B, 219A, 219B) and the opening of the first and second switchover valves (145, 245) are automatically initiated based on executable instructions provided by the control panel modules (101, 201).

11. The liquid cooling method (50) of anyone of claims 8 to 10 wherein the closing of the identified failing liquid distribution circuits valves (119A, 119B, 219A, 219B) and the opening of the first and second switchover valves (145, 245) are conducted manually by an operator in response to the issue alerts provided by the control panel modules (101, 201).

12. The liquid cooling method (50) of anyone of claims 8 to 11 wherein, after opening the first and second switchover valves (145, 245), the control panel modules (101, 201) operate to activate both pumps (112A, 112B or 212A, 212B) of the operational forward liquid circuit to maximize liquid cooling flow routed to the identified failing cooling arrangement (100, 200).

13. The liquid cooling method (50) of anyone of claims 8 to 12, wherein after opening the first and second switchover valves (145, 245), the control panel modules (101, 201) operate to increase the speed of the fan assemblies (110A, 210A) of the dry cooling unit (110, 210) pertaining to the operational cooling arrangement to maximize the cooling liquid flow routed to the identified failing cooling arrangement (100, 200).
